# EUROPÄISCHE PATENTANMELDUNG

(11) **EP 2 709 152 A2**
(43) Veröffentlichungstag der Anmeldung: **19.03.2014**
(21) Anmeldenummer: 13181199.4
(22) Anmeldetag: 21.08.2013
(51) Int. Cl.: H01L 23/427

(54) **Kühlkreislauf mit ausreichend knapp bemessenem Wärmetauscher**

(30) Priorität: 12.09.2012 DE 202012008739 U
(71) Anmelder: ABB Technology AG, 8050 Zürich (CH)
(72) Erfinder: Habert, Mathieu, 4310 Rheinfelden (CH); Apeldoorn, Oscar, 5426 Lengnau (CH); Gradinger, Thomas, 5032 Rohr (CH)
(74) Vertreter: ABB Patent Attorneys

(57) **Zusammenfassung**

Leistungselektronikmodul (1) mit einem ersten Leistungselektronikelement (5), welches im Betrieb des Leistungselektronikmoduls (1) einen ersten Wärmestrom (29) erzeugt, und mit einem zweiten Leistungselektronikelement (6), welches im Betrieb des Leistungselektronikmoduls (1) einen zweiten Wärmestrom (30) erzeugt, und mit einem Sekundärkühlkreislauf (25), einem ersten Kühler (10), einem zweiten Kühler (11) und einem Wärmetauscher (14). Dabei ist der erste Kühler (10) zur Aufnahme mindestens eines Teils des ersten Wärmestromes (29) thermisch mit dem ersten Leistungselektronikelement (5) verbunden, und der zweite Kühler (11) zur Aufnahme mindestens eines Teils des zweiten Wärmestromes (30) thermisch mit dem zweiten Leistungselektronikelement (6) verbunden, wobei der Wärmetauscher (14) zur Übertragung mindestens eines Teils des ersten Wärmestromes (29) und des zweiten Wärmestromes (30) an einen Primärkühlstrom (26) im Betrieb des Leistungselektronikmoduls (1) ausgebildet ist. Der Wärmetauscher (14) ist dabei thermisch für einen abführbaren Wärmestrom ausgelegt, der betragsmässig kleiner als eine aus dem maximalen ersten Wärmestrom (29) und dem maximalen zweiten Wärmestrom (30) gebildete Summe ist.

## Beschreibung

### TECHNISCHES GEBIET

Die Erfindung bezieht sich auf das Gebiet der Wärmeabfuhr von Leistungselektronik aus einem Leistungselektronikmodul, oder einem einen Leistungselektronikmodul aufweisenden Umrichter, insbesondere mittels eines Thermosiphon-Kühlkreislaufs.

### STAND DER TECHNIK

Elektrische und elektronische Elemente der Leistungselektronik sind oft wie Halbleiterelemente, beispielswiese IGBT's, Thyristoren, Dioden, Widerstände, MOSFET's, sowie Kombinationen solcher Bauelemente und dergleichen zu verstehen. Unter dem Begriff Leistungselektronik werden nachfolgend Leistungselektronik-Elemente verstanden, welche im Betrieb typischerweise eine Sperrspannung von mehr als 500 Volt aufweisen. Diese elektrischen und elektronischen Elemente müssen im Betrieb gekühlt werden, da sie aufgrund der sehr hohen Leistungsdichten ebenfalls sehr hohe Wärmeströme generieren, die es effizient abzuführen gilt. In modernen Umrichtern sind diese Leistungselektronikelemente oft gruppenweise in Leistungsmodulen zusammengefasst. Ein Umrichter kann beispielsweise zum Antreiben einer Industriemühle, einem Fahrzeug, einem Schiff und/oder generell zur Spannungsumwandlung oder Spannungsumwandlung verwendet werden.

Wenn die Wärme nicht aus den Halbleiterelementen abgeführt wird, können diese beschädigt werden, was im Extremfall dazu führen kann, dass ein Betreiber des Umrichters Betriebsunterbrüche infolge Reparaturen hinnehmen muss. Solche Betriebsunterbrüche gilt es zu vermeiden, da sie für den Betreiber des Umrichters zu erheblichen wirtschaftlichen Nachteilen führen können.

Da mit zunehmender Miniaturisierung von Umrichtern die Leistungsdichte pro Bauvolumen des Umrichters steigt, steigt der Bedarf an kompakten, aber dennoch leistungsfähigeren Kühlsystemen zunehmend. Die Abfuhr der Wärmeströme der Leistungselektronik aus einem Umrichter erfolgt im Betrieb des Umrichters typischerweise entweder über einen mit dem Umrichter verbundenen Kühlwasserstrom oder einen Kühlluftstrom eines Primärkreislaufes über einen Wärmetauscher. Dabei werden die Wärmeströme der Leistungselektronikelemente mittels eines Sekundärkühlkreislaufes über einen Wärmetauscher an den Primärkühlstrom übertragen.

Sowohl im Fall des Primärkühlstroms in Form eines Kühlwasserstroms, als auch im Fall des Primärkühlstroms in Form eines Kühlluftstrom bildet die vom Sekundärkühlkreislauf über den

Wärmetauscher an den Primärkühlstrom thermisch zu übertragende Leistung eine kritische Grösse, denn diese Grösse beeinflusst den Bedarf an Bauvolumen für die Unterbringung von Kühlkanälen ausreichenden Querschnitts, sowie von Pumpen, Ventilatoren und dergleichen.

Die Aufgabe der Erfindung besteht daher darin, einen verbesserten Leistungselektronikmodul und einen verbesserten Umrichter vorzulegen, mit welchem sich im Vergleich zu bekannten Leistungselektronikmodulen bzw. Umrichtern der gleichen Leistungsklasse geringere Bauvolumen erreichen lassen. Unter dem Begriff Bauvolumen wird dabei der Platzbedarf hinsichtlich seiner räumlichen, dimensionsmässigen Abmessungen verstanden.

### DARSTELLUNG DER ERFINDUNG

Diese Aufgabe wird durch einen Leistungselektronikmodul gemäss Anspruch 1 gelöst.

Bekannte Leistungselektronikmodule haben im Betrieb mitunter nicht nur einen ersten Betriebszustand, sondern auch einen zweiten Betriebszustand (bzw. Schaltfall), in welchem die elektrische Schaltung der Leistungselektronikelemente unterschiedlich zum ersten Betriebszustand ist. Dementsprechend erfordern nicht nur die dem ersten Schaltfall zugeordneten ersten Leistungselektronikelemente eine thermische Kühlung, sondern auch die dem zweiten Schaltfall zugeordneten Leistungselektronikelemente. Zu diesem Zweck sind die ersten Leistungselektronikelemente oft über erste Kühler zur Aufnahme des ersten Wärmestromes thermisch mit den ersten Leistungselektronikelementen verbunden ist, während die zweiten Leistungselektronikelemente oft über zweite Kühler zur Aufnahme des zweiten Wärmestromes thermisch mit den zweiten Leistungselektronikelementen verbunden sind.

Wenn im Betrieb nun gewisse Leistungselektronikelemente sowohl im ersten Betriebszustand, als auch im zweiten Betriebszustand einen Wärmestrom generieren, welchen es über den Wärmetauscher an den Primärkühlstrom abzuführen gilt, so wurde der Wärmetauscher typischerweise thermisch für einen abführbaren Wärmestrom ausgelegt wurde, der betragsmässig der Summe aus dem maximalen ersten Wärmestrom und dem maximalen zweiten Wärmestrom entspricht. Dies führte dazu, dass sowohl der Wärmetauscher, als auch der Primärkühlstrom mit dessen Kanalelementen und Antriebsmittels zur Erzeugung des Primärkühlstroms, beispielsweise einer Pumpe oder eines Ventilators, dementsprechend dimensioniert wurde.

Bei näherer Untersuchung hat sich jedoch gezeigt, dass der maximale erste Wärmestrom in einem ersten Betriebszustand des Leistungselektronikmoduls eintritt, während der maximale zweite Wärmestrom in einem bezüglich des ersten Betriebszustands zeitlich versetzten zweiten Betriebszustandes des Leistungselektronikmoduls eintritt, so dass die Summe aus dem maximalen ersten Wärmestrom und dem maximalen zweiten Wärmestrom in der Realität gar nie auftritt und deshalb auch nie an den Primärkühlstrom abgeführt werden muss, da der tatsächlich abzuführende Wärmestrom stets geringer war. Als Folge davon zeigte sich, dass der bisherige Primärkühlstrom und alle ihm zugeordneten Elemente wie Kanalquerschnitt, Pumpen, Ventilatoren und dergleichen stets zu gross bemessen waren.

Im Vergleich zu konventionellen Lösungen kann mit einer Lösung gemäss dem vorliegenden Erfindungsgedanken das Bauvolumen des Wärmetauschers geringer gehalten werden, indem der Leistungselektronikmodul folgende Elemente in folgender Konfiguration umfasst:
- ein erstes Leistungselektronikelement, welches im Betrieb des Leistungselektronikmoduls einen ersten Wärmestrom erzeugt;
- ein zweites Leistungselektronikelement, welches im Betrieb des Leistungselektronikmoduls einen zweiten Wärmestrom erzeugt;
- einen Sekundärkühlkreislauf mit einem ersten Kühler, einem zweiten Kühler und einem Wärmetauscher; wobei der erste Kühler zur Aufnahme des ersten Wärmestromes thermisch mit dem ersten Leistungselektronikelement verbunden ist, und wobei der zweite Kühler zur Aufnahme des zweiten Wärmestromes thermisch mit dem zweiten Leistungselektronikelement verbunden ist;
- der Wärmetauscher ist zur Übertragung mindestens eines Teils des ersten Wärmestromes und des zweiten Wärmestromes an einen Primärkühlstrom im Betrieb des Leistungselektronikmoduls ausgebildet;
- der erfindungsgemässe Wärmetauscher ist thermisch für einen abführbaren Wärmestrom ausgelegt ist, der betragsmässig kleiner als eine aus dem maximalen ersten Wärmestrom und dem maximalen zweiten Wärmestrom gebildete Summe.

Wie vorher bereits kurz erwähnt, liegt ein erster Vorteil eines solchen Leistungselektronikmoduls darin, dass der Wärmetauscher ein geringeres Bauvolumen erfordert, als bekannte Wärmetauscher von Leistungselektronikmodulen der gleichen Leistungsklasse. In der Folge lassen sich damit volumenmässig kompaktere Leistungselektronikmodulen erzielen.

Ein weiterer Vorteil liegt darin, dass der erfindungsgemässe Wärmetauscher im Vergleich zu bekannten Wärmetauschern von Leistungselektronikmodulen der gleichen Leistungsklasse weniger Leistung vom Primärkühlstrom erfordert. In der Folge können die erforderlichen Leistungen der Mittel zur Erzeugung des Primärstroms wie etwa Ventilatoren im Fall einer Luftkühlung oder einer Pumpeneinheit im Fall einer Flüssigkeitskühlung, etwa in Form einer Wasserkühlung, gesenkt werden. Dies ermöglicht beispielsweise den Einsatz von Ventilatoren oder Pumpen einer geringeren Leistungsklasse, als bisher. Solche Ventilatoren oder Pumpen sind nicht nur oft kompakter, sondern auch beträchtlich kostengünstiger als die bislang eingesetzten Typen der höheren Leistungsklasse.

Je nach Ausführungsform des Leistungselektronikmoduls kann der Sekundärkühlkreislauf ein Flüssigkeitskreislauf sein, in welchem das Arbeitsmedium im Wesentlichen stets in flüssigem Zustand bleibt, oder aber ein Thermosiphon-Kühlkreislauf, in welchem das Arbeitsmedium in mindestens einem Verdampfer verdampft und anschliessend in einem Kondensator kondensiert und in flüssiger Form an den Verdampfer zurückgeleitet wird, um den Zyklus erneut zu durchlaufen. In diesem Fall ist der erste Kühler durch einen ersten Verdampfer gebildet und der zweite Kühler durch einen zweiten Verdampfer gebildet, wobei der Wärmetauscher einen Kondensator zur Verflüssigung eines Arbeitsmediums des Sekundärkühlkreislaufs aufweist.

Besonders dann, wenn der Sekundärkühlkreislauf ein Thermosiphon-Kühlkreislauf ist, ist es hinsichtlich des thermischen Wirkungsgrades vorteilhaft, wenn der Sekundärkühlkreislauf in Form einer geschlossenen Schlaufe (als loop-type thermosiphon) ausgebildet ist.

Besonders dann, wenn mehrere Kühler und mehrere Leistungselektronikelement zu einem Verbund, beispielsweise einem Stapel (englisch als "press-pack stack" bekannt) angeordnet sind, empfiehlt es sich, wenn der erste Kühler fluidisch stets parallel zum zweiten Kühler im Kühlkreislauf angeordnet ist. Dies gilt insbesondere dann, wenn der erste Kühler und der zweite Kühler vom gleichen Typ sind und daher etwa denselben Druckabfall über dem Kühler, das heisst zwischen einem ersten Kühlanschluss (Eingang) und einem zweiten Kühlanschluss (Ausgang) aufweisen. Ein weiterer Vorteil liegt darin, dass im Unterschied zu einer seriellen Anordnung der Kühler im Sekundärkreislauf beide Kühler ein Arbeitsmedium von etwa derselben Eingangstemperatur erhalten und nicht ein von einem fluidisch stromaufwärts gelegenen Kühler bereits vorgewärmtes Arbeitsmedium, so dass der thermische Wirkungsgrad vergleichsweise höher ist.

Mit einem Leistungselektronikmodul gemäss dieser Offenbarung sind besonders dann gute thermische Ergebnisse erzielbar, wenn sich das zweite Leistungselektronikelement vom ersten Leistungselektronikelement unterscheidet, insbesondere vom Typ her unterscheidet. Dies gilt speziell dann, wenn das erste Leistungselektronikelement und das zweite Leistungselektronikelement derart angeordnet und konfiguriert sind, dass der maximale erste Wärmestrom in einem ersten Betriebszustand des Leistungselektronikmoduls eintritt, während der maximale zweite Wärmestrom in einem bezüglich des ersten Betriebszustands zeitlich versetzten zweiten Betriebszustandes des Leistungselektronikmoduls eintritt. Dabei kann je nach Ausführungsform des Leistungselektronikmoduls der erste Wärmestrom im ersten Betriebszustand betragsmässig grösser als der erste Wärmestrom im zweiten Betriebszustand sein, und der zweite Wärmestrom im zweiten Betriebszustands betragsmässig grösser als der zweite Wärmestrom im ersten Betriebszustand sein.

Die genannten Argumente bezüglich des Leistungselektronikmoduls gelten entsprechend auch für den Umrichter beziehungsweise übertragen sich auf einen Umrichter.

Wenn hohe Leistungsdichten realisiert werden sollen, empfiehlt es sich, die Leistungselektronikelemente und die Verdampfer derart anzuordnen, dass sie einen Stapel bilden. Je nach Ausführungsform einen Stapel, bei welchem Leistungselektronikelemente und Verdampfer in abwechselnder Reihenfolge angeordnet sind.

Je nachdem, wie die Umgebung des Umrichters und/oder des Leistungselektronikmoduls bereits über allfällige Vorrichtungen zum Kühlen von anderen Gerätschaften aussieht, kann es vorteilhaft sein, wenn diese Vorrichtungen zum Kühlen ebenfalls zur Erbringung einer Kühlwirkung der Leistungselektronikelemente genutzt werden. Dementsprechend kann der Primärkühlstrom ein Flüssigkeitskühlstrom mit einem Wasseranteil oder ein gasförmiger Kühlstrom sein. Je nach Ausführungsform eines gasförmigen Kühlstroms kann dieser beispielsweise ein Abgasstrom oder ein Luftstrom sein.

Falls eine bequeme, rationelle Austauschbarkeit der Leistungselektronikmodule im Umrichter erforderlich ist, sind gute Ergebnisse erzielbar, wenn das mindestens eine Leistungselektronikmodul schubladenartig in den Umrichter hineinschiebbar und aus dem Umrichter herausziehbar ist, wobei der Wärmetauscher auf diesem Leistungselektronikmodul angeordnet ist. Der Vorteil erhöht sich noch zusätzlich, wenn ein Umrichter mehrere solcher Leistungselektronikmodule aufweist, welche auf diese Art in den Umrichter einführbar und aus diesem entnehmbar sind.

### KURZE BESCHREIBUNG DER ZEICHNUNGEN

Nachfolgend werden mehrere Ausführungsformen der Erfindung anhand der Zeichnung detailliert erläutert. Hierbei zeigt rein schematisch
- FIG. 1: eine Ausführungsform eines Leistungselektronikmoduls in einem ersten Betriebszustand;
- FIG. 2: die Ausführungsform eines Leistungselektronikmoduls gemäss Figur 1 in einem zweiten Betriebszustand;
- FIG. 3: ein Wärmestrom-Zeit-Diagramm des Leistungselektronikmoduls mit zwei unterschiedlichen Leistungselektronikelementen beim Übergang vom ersten Betriebszustand in den zweiten Betriebszustand; und
- FIG. 4: eine Vergleichsdarstellung der Wärmeströme zweier unterschiedlicher Leistungselektronikelemente des Leistungselektronikmoduls zu einer konventionellen Maximalwärmestromermittlung.

Die in der Zeichnung verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen. Die beschriebenen Ausführungsformen stehen beispielhaft für den Erfindungsgegenstand und haben keine beschränkende Wirkung.

### WEG ZUR AUSFÜHRUNG DER ERFINDUNG

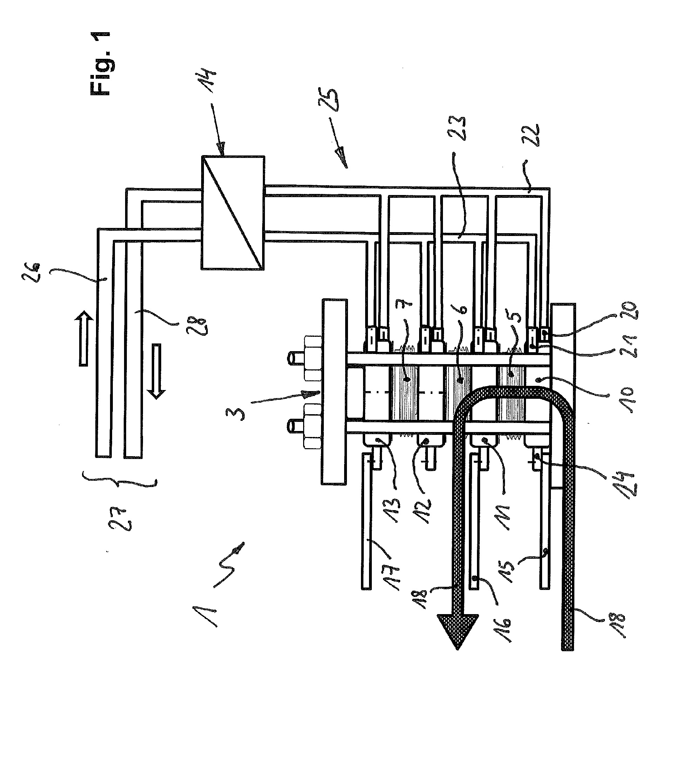

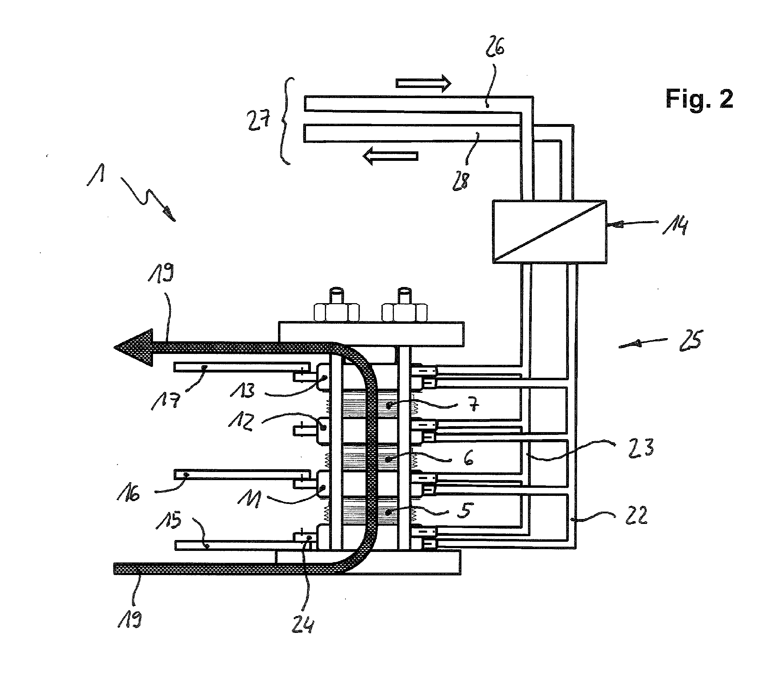

Die Figur 1 zeigt eine erste Ausführungsform eines Leistungselektronikmoduls 1 mit drei Leistungselektronikelementen einem ersten Betriebszustand. Der Leistungselektronikmodul 1 weist drei Leistungselektronikelemente auf, welche alternierend mit mehreren Kühlern zu einem Stapel 3 zusammengespannt sind, während in **Figur 2** ein zweiter Betriebszustand des Leistungselektronikmoduls 1 gezeigt ist.

Von den drei Leistungselektronikelementen sei für die folgende Erklärung das im Stapel 3 zuunterst angeordnete Leistungselektronikelement das "erste Leistungselektronikelement" 5, während das in vertikaler Richtung des Stapels 3 darauffolgende Leistungselektronikelement nachfolgend als "zweites Leistungselektronikelement" 6 genannt wird. Das im Stapel 3 zuoberst angeordnete, dritte Leistungselektronikelement 7 kann wiederum vom Typ des ersten Leistungselektronikelements 5 sein - muss es jedoch nicht zwingend. Zur Klarstellung sei noch erwähnt, dass das zweite Leistungselektronikelement 6 zwei Schaltstellungen haben kann, nämlich ein Durchleiten des Nominalstroms in seiner ersten Schaltstellung und ein Sperren des Nominalstroms in seiner zweiten Schaltstellung. Im ersten Betriebszustand des Leistungselektronikmoduls 1 befindet sich das zweite Leistungselektronikelement 6 in der ersten Schaltstellung, während es sich im zweiten Betriebszustand des Leistungselektronik-moduls 1 in der zweiten Schaltstellung befindet. Der Übergang vom ersten Betriebszustand in den zweiten Betriebszustand kann dabei sehr rasch erfolgen, das heisst innert Sekunden-bruchteilen.

Der oben beschriebene Aufbau und die Funktion des Leistungselektronikmoduls 1 sind beispielshaft zu verstehen. In Varianten des Leistungselektronikmoduls kann das zweite Leistungselektronikelement beispielsweise eine Snubber-Diode sein und ein weiteres Halbleiterelement sein, welche das dritte Leistungselektronikelement 7 und daran angeschlossene Elemente vor ungewollter Beschädigung infolge einer Überspannung schützen kann, indem sie den in den Stapel eintretenden Stromfluss in einen anderen Strompfad (meist temporär) umleiten. In diesem wäre der Aufbau des Stapels 3 allerdings dann anders zum in Figur 1 gezeigten Aufbau, indem er konventionelle interne Verschienungen und Isolierstücke aufweisen würde, so dass die drei Leistungselektronikelemente 5, 6, 7 elektrisch nicht mehr in Serie geschaltet sein würden, so wie in Figur 1 und Figur 2 gezeigt. Da eine detailliertere Darstellung und Beschreibung der Verständlichkeit der vorliegenden Erfindungsidee abträglich sein würden, wird auf die stark vereinfachten Schaltmöglichkeiten des Leistungselektronik-moduls 1 zurückverwiesen.

Zurückkommend auf den Stapel 3 gemäss Figur 1 ist unterhalb des ersten Leistungselektronikelementes 5 ein erster Kühler 10 zur Aufnahme eines Wärmestromes des ersten Leistungselektronikelementes 5 angeordnet. Zwischen dem ersten Leistungselektronikelement 5 und dem zweiten Leistungselektronikelement 6 ist ein zweiter Kühler 11 angeordnet, welcher sowohl zur Aufnahme eines Wärmestromes des ersten Leistungselektronikelements 5, als auch eines Wärmestromes des zweiten Leistungselektronikelements 6 dient. Zwischen dem zweiten Leistungselektronikelement 6 und dem dritten Leistungselektronikelement 7 ist ein dritter Kühler 12 angeordnet, welcher sowohl zur Aufnahme eines Wärmestromes des zweiten Leistungselektronikelements 6, als auch eines Wärmestromes des dritten Leistungselektronikelements 7 dient. Auf seiner dem dritter Kühler 12 abgewandten Seite des dritten Leistungselektronikelements 7 ist schliesslich ein vierter Kühler 13 angeordnet, welcher ebenfalls zur Aufnahme eines Wärmestromes des dritten Leistungselektronikelements 7 beiträgt.

Anders ausgedrückt, sind alle Leistungselektronikelemente 5, 6, 7 sandwichartig zwischen je einem Kühlerpaar 10, 11; 11, 12; 12, 13 angeordnet.

Jeder Kühler 10, 11, 12, 13 weist eine Anschlusslasche 24 zum elektrischen Abgreifen eines elektrischen Stromes auf. Im Leistungselektronikmodul 1 gemäss Figur 1 wird im Betrieb des Leistungselektronikmoduls 1 jedoch nicht an allen Kühlern der jeweilige elektrische Strom abgegriffen, sondern lediglich am ersten Kühler 10, welcher dazu mit einer Eingangs-Stromschiene 15 elektrisch verbunden ist, am zweiten Kühler, welcher dazu mit einer Bypass-Stromschiene 16 elektrisch verbunden ist, sowie dem vierten Kühler 13, welcher dazu mit einer Ausgangs-Stromschiene 17 elektrisch verbunden ist.

Im ersten Betriebszustand des Leistungselektronikmoduls 1 befindet sich das zweite Leistungselektronikelement 6 in der ersten Schaltstellung, während es sich im zweiten Betriebszustand des Leistungselektronikmoduls 1 in der zweiten Schaltstellung befindet. Obwohl ein solches Schaltverhalten bei Hochspannungsschaltanlagen in der Regel nicht mehr mit einem einzigen Bauteil abgedeckt werden kann, kann zur Erklärung der Erfindung das zweite Leistungselektronikelement 6 als ein elektrischer Doppelschalter verstanden werden, welcher sowohl im ersten Betriebszustand, als auch im zweiten Betriebszustand des Leistungselektronikmoduls 1 einen zweiten Wärmestrom erzeugt, denn ein Fachmann auf diesem Fachgebiet weiss, wie er den mechanischen Aufbau eines Stapels konkret zu bilden hat.

Im ersten Betriebszustand des Leistungselektronikmoduls 1 blockt das zweite Leistungselektronikelement 6 also den über den ersten Kühler 10 in den Stapel 3 eintretenden Stromfluss durch den Stapel am zweiten Kühler 11 ab, so dass der Stromfluss den Stapel 3 über die Bypass-Stromschiene 16 entlang einem ersten Strompfad 18 wieder verlässt.

Im zweiten Betriebszustand des Leistungselektronikmoduls 1 leitet das zweite Leistungselektronikelement 6 den über den ersten Kühler 10 in den Stapel 3 eintretenden Stromfluss durch den zweiten Kühler 11 und sich hindurch über das dritte Leistungselektronikelement 7 auf den vierten Kühler 13 und die Ausgangs-Stromschiene 16 entlang einem zweiten Strompfad 19 ab und sperrt den Strompfad zur Bypass-Stromschiene 16 elektrisch ab.

Jeder Kühler 10, 11, 12, 13 weist einen ersten Kühlanschluss 20 und einen zweiten Kühlanschluss 21 auf, welche jeweils über ein erstes Rohrsystem 22 und ein zweites Rohrsystem 23 mit einem Wärmetauschers 14 fluidisch verbunden sind und so ein Sekundärkühlkreislauf 25 in Form einer geschlossenen Schlaufe bilden. Zur Vermeidung eines elektrischen Kurzschlusses zwischen zwei benachbarten Kühlern, welche im Betrieb des Leistungselektronikmoduls 1 auf unterschiedlichen elektrischen Potentialen liegen, sind das erste Rohrsystem 22 und das zweite Rohrsystem 23 zumindest teilweise elektrisch isolierend, während das Arbeitsmedium des Sekundärkühlkreislaufs elektrisch isolierend ist.

Der Wärmetauscher 14 übergibt im Betrieb des Leistungselektronikmoduls 1 einen überwiegenden Teil der Summe aller von den Kühlern aufgenommenen Wärmeströme einem Primärkühlstrom 26 eines Primärkühlsystems 27. Wenn das Primärkühlsystem ebenfalls ein (geschlossener) Kühlkreislauf ist, verlässt der Wärmestrom vom ersten Rohrsystem 22 den Wärmetauscher über einen Primärstromrückführung 28.

In der vorliegenden Ausführungsform des Leistungselektronikmoduls 1 ist der Sekundärkühlkreislauf 25 ein Thermosiphon-Kühlkreislauf, in welchem ein Arbeitsmedium in mindestens einem der als Verdampfer wirkenden Kühler 10, 11, 12, 13 verdampft und anschliessend im als Kondensator wirkenden Wärmetauscher 14 kondensiert und in flüssiger Form an die Verdampfer 10, 11, 12, 13 zurückgeleitet wird, um den Zyklus erneut zu durchlaufen.

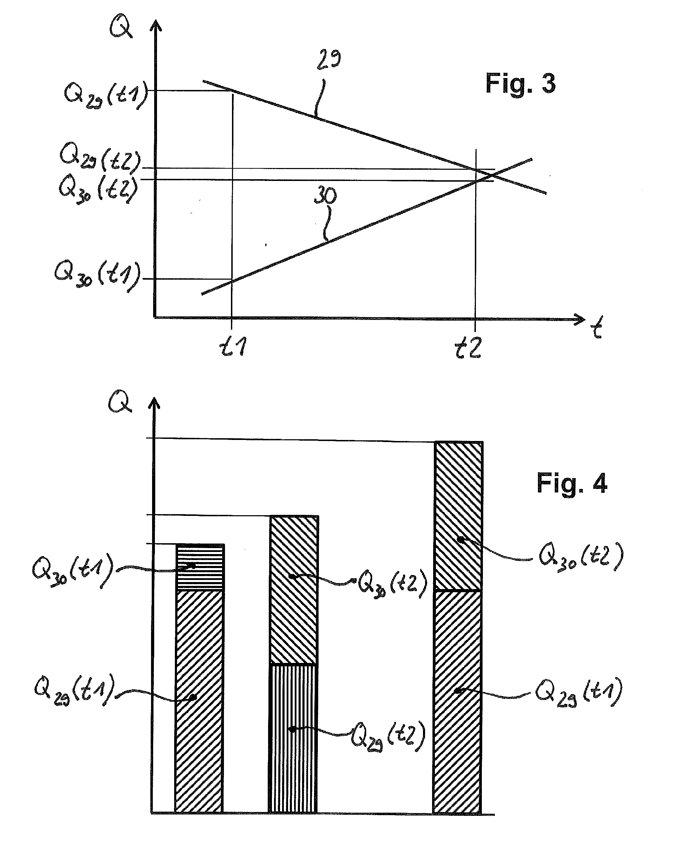

Die **Figur 3** zeigt ein Wärmestrom-Zeit-Diagramm (Q-t-Diagramm) des Leistungselektronikmoduls beim Übergang vom ersten Betriebszustand in den zweiten Betriebszustand. Dabei ist das erste Leistungselektronikelemente 5 vom elektrischen Schaltverhalten und der Schaltanordnung im Leistungselektronikmodul 1 her unterschiedlich zur zweiten Leistungselektronikelemente 6 konfiguriert und angeordnet. Dementsprechend anders sind die Belastungskennlinien der Wärmeströme 29, 30 der ersten Leistungselektronikelemente 5 bzw. der zweiten Leistungselektronikelemente 6.

Beim Betrieb des Leistungselektronikmoduls 1 im ersten Betriebszustand zum Zeitpunkt t1 erzeugt das erste Leistungselektronikelement 5 einen ersten Wärmestrom 29, während das zweite Leistungselektronikelement 6 einen zweiten Wärmestrom 30 erzeugt. Der erste Wärmestrom 29 und der zweite Wärmestrom 30 werden über den Sekundärkreislauf 25 dem Primärkühlsystems 27 übergeben. Da das zweite Leistungselektronikelement 6 zu diesem Zeitpunkt t1 den ersten Stromfluss 18 abblockt und in Richtung der Bypass-Stromschiene 16 umleitet, ist der zweite Wärmestrom 30 betragsmässig kleiner als der erste Wärmestrom 29.

Beim Betrieb des Leistungselektronikmoduls 1 im ersten Betriebszustand zum Zeitpunkt t1 wird der erste Wärmestrom 29 über die Kühler 10, 11 an den Sekundärkreislauf 25 übertragen, während der zweiten Wärmestrom 30 .über die Kühler 11, 12 an den Sekundärkreislauf 25 übertragen wird.

Wie in Zusammenschau von Figur 3 mit **Figur 4** hervorgeht, erzeugt das erste Leistungselektronikelement 5 beim Betrieb des Leistungselektronikmoduls 1 im zweiten Betriebszustand zum Zeitpunkt t2 einen ersten Wärmestrom 29, welcher nun betragsmässig geringer ist, als der erste Wärmestrom 29 im ersten Betriebszustand. Dies rührt daher, als dass die Spannung über dem Leistungselektronikmodul 1 nun nicht mehr alleine über dem ersten Leistungselektronikelement 5 abfällt, sondern über allen Leistungselektronikelementen 5, 6, 7 gemeinsam. Da das zweite Leistungselektronikelemente 6 zu diesem Zeitpunkt t2 den zweiten Stromfluss 19 nun in Richtung der Abgangs-Stromschiene 17 durchleitet und den ersten Strompfad 18 in Richtung der Bypass-Stromschiene 16 absperrt, ist der zweite Wärmestrom 30 zum im zweiten Betriebszustand (zum Zeitpunkt t2) betragsmässig grösser als im ersten Betriebszustand (zum Zeitpunkt t1).

In der im Stil eines Säulendiagramms gehaltenen Säule rechts ist zum Vergleich der maximale erste Wärmestrom 29 (Q₂₉(t1) zum Zeitpunkt t1) und der maximale zweite Wärmestrom 30 (Q₃₀(t2) zum Zeitpunkt t2) in Summe dargestellt. Wie oben erwähnt, wurde der Wärmetauscher 14 konventionell nach diesem summarischen Wärmestrom ausgewählt. Da die Säule des summarischen Wärmestroms im zweiten Betriebszustand mit Q₂₉(t2) plus Q₃₀(t2) zwar grösser ist, als im ersten Betriebszustand mit Q₂₉(t1) plus Q₃₀(t1), jedoch betragsmässig doch deutlich geringer als der summarischen Wärmestrom nach der konventionell selektierten Säule mit Q₂₉(t1) plus Q₃₀(t2) (ganz rechts im Säulendiagramm), kann der Wärmetauscher von seiner thermischen Leistungsfähigkeit her knapper bemessen werden als bislang, denn zur ausreichenden Übertragung des ersten Wärmestroms 29 und des zweiten Wärmestroms 30 an den Sekundärkreislauf 25 reicht die Kühlleistung gemäss dem zweiten Betriebszustand mit Q₂₉(t2) plus Q₃₀(t2) aus.

### BEZUGSZEICHENLISTE

- 1: Leistungselektronikmodul
- 3: Stapel
- 5: erstes Leistungselektronikelement
- 6: zweites Leistungselektronikelement
- 7: drittes Leistungselektronikelement
- 10: erster Kühler / Verdampfer
- 11: zweiter Kühler / Verdampfer
- 12: dritter Kühler / Verdampfer
- 13: vierter Kühler / Verdampfer
- 14: Wärmetauscher / Kondensator
- 15: Eingangs-Stromschiene
- 16: Bypass-Stromschiene
- 17: Ausgangs-Stromschiene
- 18: erster Stromfluss / Strompfad
- 19: zweiter Stromfluss/ Strompfad
- 20: erster Kühlanschluss
- 21: zweiter Kühlanschluss
- 22: erstes Rohrsystem
- 23: zweites Rohrsystem
- 24: Anschlusslasche
- 25: Sekundärkühlkreislauf
- 26: Primärkühlstrom
- 27: Primärkühlsystem
- 28: Primärstromrückführung
- 29: erster Wärmestrom
- 30: zweiter Wärmestrom

## Patentansprüche

1. Leistungselektronikmodul (1), umfassend
ein erstes Leistungselektronikelement (5), welches im Betrieb des Leistungselektronikmoduls (1) einen ersten Wärmestrom (29) erzeugt,
ein zweites Leistungselektronikelement (6), welches im Betrieb des Leistungselektronikmoduls (1) zur Erzeugung eines zweiten Wärmestroms (30) beiträgt,
einen Sekundärkühlkreislauf (25) mit einem ersten Kühler (10), einem zweiten Kühler (11) und einem Wärmetauscher (14),
wobei der erste Kühler (10) zur Aufnahme mindestens eines Teils des ersten Wärmestromes (29) thermisch mit dem ersten Leistungselektronikelement (5) verbunden ist,
und wobei der zweite Kühler (11) zur Aufnahme mindestens eines Teils des zweiten Wärmestromes (30) thermisch mit dem zweiten Leistungselektronikelement (6) verbunden ist, und wobei der Wärmetauscher (14) zur Übertragung mindestens eines Teils des ersten Wärmestromes (29) und des zweiten Wärmestromes (30) an einen Primärkühlstrom (26) im Betrieb des Leistungselektronikmoduls (1) ausgebildet ist,
**dadurch gekennzeichnet, dass** der Wärmetauscher (14) thermisch für einen abführbaren Wärmestrom ausgelegt ist, der betragsmässig kleiner als eine aus dem maximalen ersten Wärmestrom (29) und dem maximalen zweiten Wärmestrom (30) gebildete Summe ist.

2. Leistungselektronikmodul nach Anspruch 1, **dadurch gekennzeichnet, dass** der Sekundärkühlkreislauf (25) als Kühlkreislauf in Form einer geschlossenen Schlaufe ausgebildet ist.

3. Leistungselektronikmodul nach Anspruch 2, **dadurch gekennzeichnet, dass** der erste Kühler (10) fluidisch parallel zum zweiten Kühler (11) im Sekundärkühlkreislauf (25) angeordnet ist.

4. Leistungselektronikmodul nach Anspruch 2 oder 3, **dadurch gekennzeichnet, dass** der Sekundärkühlkreislauf (25) als Thermosiphon-Kühlkreislauf ausgebildet ist,
wobei der erste Kühler (10) durch einen ersten Verdampfer gebildet ist und der zweite Kühler (11) durch einen zweiten Verdampfer gebildet ist, und wobei der Wärmetauscher (14) einen Kondensator zur Verflüssigung eines Arbeitsmediums des Sekundärkühlkreislaufs (25) aufweist.

5. Leistungselektronikmodul nach einem der vorangehenden Ansprüche, **dadurch gekennzeichnet, dass** sich das zweite Leistungselektronikelement (6) vom ersten Leistungselektronikelement (5) unterscheidet, insbesondere vom Typ her unterscheidet.

6. Leistungselektronikmodul nach einem der vorangehenden Ansprüche, **dadurch gekennzeichnet, dass** das erste Leistungselektronikelement (5) und das zweite Leistungselektronikelement (6) derart angeordnet und konfiguriert sind, dass der maximale erste Wärmestrom (29) in einem ersten Betriebszustand des Leistungselektronikmoduls (1) eintritt, während der maximale zweite Wärmestrom (30) in einem bezüglich des ersten Betriebszustands zeitlich versetzten zweiten Betriebszustand des Leistungselektronikmoduls (1) eintritt.

7. Leistungselektronikmodul nach Anspruch 6, **dadurch gekennzeichnet, dass** der erste Wärmestrom (29) im ersten Betriebszustand betragsmässig grösser als der erste Wärmestrom (29) im zweiten Betriebszustand ist, und
dass der zweite Wärmestrom (30) im zweiten Betriebszustands betragsmässig grösser als der zweite Wärmestrom (30) m ersten Betriebszustand ist.

8. Umrichter, umfassend mindestens einen Leistungselektronikmodul (1) nach einem der vorangehenden Ansprüche.

9. Umrichter nach Anspruch 8, **dadurch gekennzeichnet, dass** die Leistungselektronikelemente (5, 6, 7) und die Kühler (10, 11, 12, 13) derart angeordnet sind, dass sie einen Stapel (3) bilden, in Ausführungsformen einen Stapel (3), bei welchem Leistungselektronikelemente (5, 6, 7) und Kühler (10, 11, 12, 13) in abwechselnder Reihenfolge angeordnet sind, wobei die Kühler (11, 12, 13) zur Erzeugung des zweiten Wärmestroms (30) beitragen.

10. Umrichter nach Anspruch 8 oder 9, **dadurch gekennzeichnet, dass** der Primärkühlstrom (26) ein Flüssigkeitskühlstrom mit einem Wasseranteil ist oder ein gasförmiger Kühlstrom ist, insbesondere ein Luftstrom.

11. Umrichter nach einem der Ansprüche 8 bis 10, **dadurch gekennzeichnet, dass** mindestens ein Leistungselektronikmodul (1) schubladenartig in den Umrichter hineinschiebbar und aus dem Umrichter herausziehbar ist, wobei der Wärmetauscher (14) auf diesem Leistungselektronikmodul (1) angeordnet ist.
